# EUROPÄISCHE PATENTSCHRIFT

(11) **EP 2 048 778 B1**
(45) Veröffentlichungstag und Bekanntmachung des Hinweises auf die Patenterteilung: **03.05.2017**
(21) Anmeldenummer: 08012263.3
(22) Anmeldetag: 08.07.2008
(51) Int. Cl.: H03K 7/08

(54) **Verfahren zum Erzeugen von PWM-Signalen**
Method for creating PWM signals
Procédé de production de signaux PWM

(30) Priorität: 09.10.2007 DE 102007048439
(43) Veröffentlichungstag der Anmeldung: 15.04.2009
(73) Patentinhaber: ETEL S.A., 2112 Môtiers (CH)
(72) Erfinder: Mottier, Samuel, 1012 Lausanne (CH)
(74) Vertreter: Pleyer, Hans Anno

(56) Entgegenhaltungen:
- EP-A1- 1 014 552
- JP-A- H04 159 821
- JP-A- 2004 357 450
- US-A1- 2005 285 582
- US-A1- 2007 195 876
- YAN-FEI LIU ET AL: "Digital control of switching power converters", CONTROL APPLICATIONS, 2005. CCA 2005. PROCEEDINGS OF 2005 IEEE CONFERE NCE ON TORONTO, CANADA AUG. 29-31, 2005, PISCATAWAY, NJ, USA,IEEE, 29. August 2005 (2005-08-29), Seiten 635-640, XP010835158, DOI: 10.1109/CCA.2005.1507198 ISBN: 978-0-7803-9354-7
- PETERCHEV A V ET AL: "QUANTIZATION RESOLUTION AND LIMIT CYCLING IN DIGITALLY CONTROLLED PWM CONVERTERS", 32ND.ANNUAL IEEE POWER ELECTRONICS SPECIALISTS CONFERENCE. PESC 2001. CONFERENCE PROCEEDINGS. VANCOUVER, CANADA, JUNE 17 - 21, 2001; [ANNUAL POWER ELECTRONICS SPECIALISTS CONFERENCE], NEW YORK, NY : IEEE, US, Bd. CONF. 32, 17. Juni 2001 (2001-06-17), Seiten 465-471, XP001054134, DOI: 10.1109/PESC.2001.954158 ISBN: 978-0-7803-7067-8
- ANGEL DE CASTRO ET AL: "High Resolution Pulse Width Modulators in FPGA", PROGRAMMABLE LOGIC, 2007. SPL '07. 2007 3RD SOUTHERN CONFERENCE O N, IEEE, PI, 1. Februar 2007 (2007-02-01), Seiten 137-142, XP031177560, ISBN: 978-1-4244-0606-7
- YANG QIU ET AL: "Proposed DPWM Scheme with Improved Resolution for Switching Power Converters", APPLIED POWER ELECTRONICS CONFERENCE, APEC 2007 - TWENTY SECOND ANNUAL IEEE, IEEE, PI, 1. Februar 2007 (2007-02-01), Seiten 1588-1593, XP031085424, ISBN: 978-1-4244-0713-2
- JIAN LI ET AL: "High Resolution Digital Duty Cycle Modulation Schemes for Voltage Regulators", APPLIED POWER ELECTRONICS CONFERENCE, APEC 2007 - TWENTY SECOND ANNUAL IEEE, IEEE, PI, 1. Februar 2007 (2007-02-01), Seiten 871-876, XP031085313, ISBN: 978-1-4244-0713-2

## Beschreibung

Die vorliegende Erfindung betrifft ein Verfahren zum Erzeugen von PWM-Signalen. Solche PWM-Signale dienen der Ansteuerung von Leistungstransistoren in einem Umrichter.

Ein Umrichter dient beispielsweise dazu, die Gleichspannung eines Zwischenkreises in einen dreiphasigen Wechselstrom zur Ansteuerung eines Elektromotors mit drei Motorphasen umzuwandeln.

Die Figur 1 zeigt ein Prinzipschaltbild eines Umrichters U, wie er beispielsweise in der DE 10 2005 061 388 A1 beschrieben ist. Mittels Halbbrückenschaltungen B mit je zwei Leistungstransistoren T wird jede Motorphase U, V, W eines Elektromotors M entweder mit der positiven Zwischenkreisspannung +Uz oder mit der negativen Zwischenkreisspannung -Uz verbunden. Hierzu wird an jede Halbbrücke B aus zwei in Reihe geschalteten Leistungstransistoren T jeweils ein logisches PWM-Signal PWM angelegt, wobei jeweils ein Leistungstransistor direkt angesteuert wird, der andere über einen Inverter I. Dadurch liegt jede Motorphase je nach logischem Pegel des jeweiligen PWM-Signals entweder auf +Uz (logisch 1) oder auf -Uz (logisch 0). Zu beachten ist, dass beim Umschalten zwischen +Uz und -Uz eine kurze Totzeit eingehalten werden muss, während der beide Leistungstransistoren T einer Halbbrücke B nicht leitend sind, um einen Kurzschluss der Zwischenkreisspannung zu vermeiden.

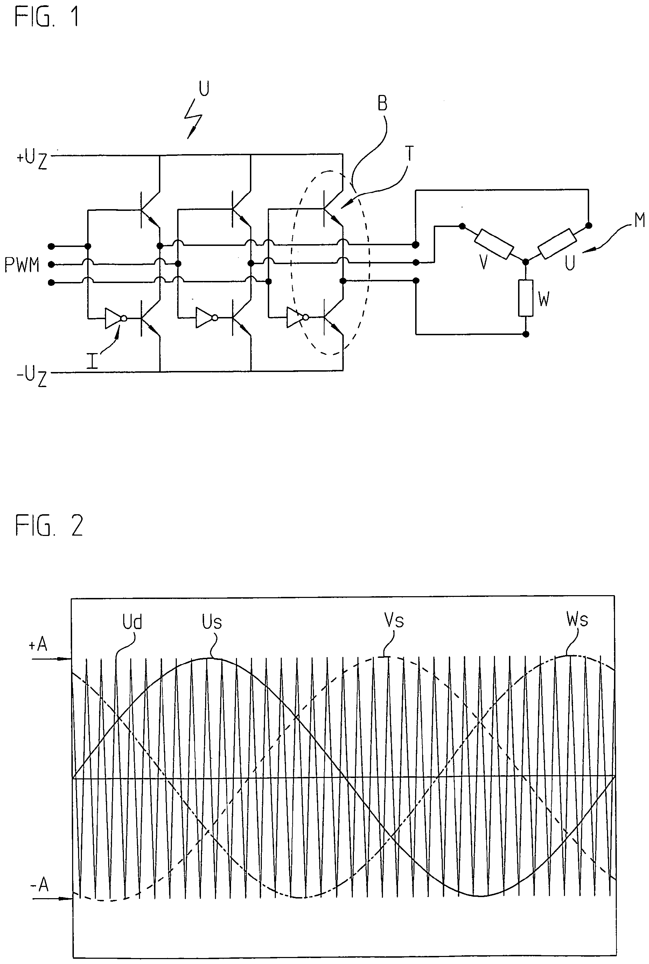

In Figur 2 ist vereinfacht eine Möglichkeit zum Erzeugen von PWM-Signalen dargestellt. Bei den PWM-Signalen handelt es sich um pulsweitenmodulierte Rechtecksignale. Für jede Motorphase U, V, W wird eine Dreieckspannung Ud mit einer Steuerspannung Us, Vs, Ws verglichen. Liegt z.B. die Steuerspannung Vs über der Dreieckspannung Ud, so ist das PWM-Signal PWM für die Motorphase V logisch 1, und die Motorphase V wird mit der positiven Zwischenkreisspannung +Uz verbunden. Liegt die Steuerspannung unter der Dreieckspannung, so ist das zugehörige PWM-Signal logisch 0, und die zugehörige Motorphase wird mit der negativen Zwischenkreisspannung -Uz verbunden. Je höher also die Steuerspannung liegt, desto länger ist die jeweilige Motorphase mit +Uz verbunden, und umgekehrt. Über das Tastverhältnis des PWM-Signals wird so die mittlere Spannung eingestellt, die an der jeweiligen Motorphase anliegt.

Je höher die auch als PWM-Frequenz bezeichnete Frequenz der Dreieckspannung Ud liegt, desto besser kann die durch die Steuerspannung vorgegebene Spannung in der Motorphase mittels Pulsweitenmodulation eingestellt werden. Höhere PWM-Frequenzen bewirken ein schnelleres Erreichen der benötigten Motorströme, sowie eine Abnahme der Stromwelligkeit und damit verbunden eine Abnahme der Wirbelstromverluste.

In digital angesteuerten Umrichtern, wie sie z.B. in der EP 1014552 A2 beschrieben sind, wird das analoge Dreieckssignal der Figur 2 durch eine Zählrampe ersetzt. Die Steuerspannung wird als variabler, digitaler Referenzwert vorgegeben, wobei der Wertebereich des Referenzwertes aus unten noch näher erläuterten Gründen in etwa mit dem Wertebereich der Zählrampe übereinstimmt, aber etwas kleiner ist.

Sind nun einerseits hoch aufgelöste Werte für den Referenzwert gewünscht, und andererseits hohe PWM - Frequenzen, so kann die benötigte Zählfrequenz sehr hoch werden, denn die Zählfrequenz ist proportional zum Produkt aus der geforderten Auflösung des Referenzwertes und der PWM-Frequenz. Die Taktraten gängiger und erschwinglicher digitaler Schaltkreise reichen hierfür unter Umständen nicht aus.

Aufgabe der Erfindung ist es daher, eine Verfahren zum Erzeugen von PWM-Signalen anzugeben, mit dem unter Einsatz erschwinglicher digitaler Schaltkreise möglichst hohe PWM-Frequenzen bei hoher Auflösung der Referenzwerte realisierbar sind.

Diese Aufgabe wird gelöst durch ein Verfahren nach Anspruch 1. Vorteilhafte Details des Verfahrens ergeben sich aus den von Anspruch 1 abhängigen Ansprüchen.

Es wird ein Verfahren zum Erzeugen eines PWM-Signals zum Ansteuern der Leistungstransistoren einer Halbbrücke eines Umrichters mittels einer digitalen Schaltung angegeben, nach dem ein digitaler Referenzwert mit dem Zählerstand einer digitalen Zählrampe verglichen wird, wobei ein logischer Zustand des PWM-Signals davon abhängt, ob der Referenzwert größer als der Zählerstand der Zählrampe ist. Dabei zählen wenigstens zwei Zähler einander abwechselnd aufeinander folgende Zählerstände der Zählrampe. Der logische Zustand des PWM-Signals hängt dabei davon ab, ob der Referenzwert größer als der Zählerstand von Zählrampen von jedem der wenigstens zwei Zähler ist.

Wird beispielsweise eine Zählrampe mit einer Zählfrequenz von 295 MHz benötigt (Details zu diesem Zahlenbeispiel folgen weiter unten), so schränkt dies die Auswahl an zur Verfügung stehenden Schaltkreisen wie z.B. FPGAs (Field Programmable Gate Arrays) erheblich ein. Verwendet man jedoch wie vorgeschlagen zwei Zähler, die mit halber Geschwindigkeit abwechselnd und damit versetzt zueinander jeweils nur gerade bzw. ungerade Werte der Zählrampe zählen, so genügt ein Schaltkreis, der Zählfrequenzen von etwa 150 MHz erlaubt. Solche Schaltkreise sind am Markt derzeit günstig zu erhalten.

Verwendet man außerdem für jeden der beiden Zähler einen geeignet ausgewählten Referenzwert, so lässt sich auf einfachste Weise die oben erwähnte Totzeit beim Umschalten zwischen den beiden Transistoren einer Halbbrückenschaltung einhalten. Andere Maßnahmen zur Einhaltung der Totzeit sind damit überflüssig und können eingespart werden.

Weitere Vorteile sowie Einzelheiten der vorliegenden Erfindung ergeben sich aus der nachfolgenden Beschreibung bevorzugter Ausführungsformen anhand der Figuren. Dabei zeigt
- Figur 1: einen Umrichter gemäß dem Stand der Technik,
- Figur 2: eine Dreiecksspannung und Steuerspannungen gemäß einem PWM-Verfahren nach dem Stand der Technik,
- Figur 3: eine Dreiecksspannung und eine Steuerspannung gemäß einem digitalen PWM-Verfahren nach dem Stand der Technik,
- Figur 4: eine Dreiecksspannung und eine Steuerspannung gemäß einem ersten Ausführungsbeispiel,
- Figur 5: eine Dreiecksspannung und zwei Steuerspannungen gemäß einem zweiten Ausführungsbeispiel,
- Figur 6: eine Logikschaltung gemäß dem zweiten Ausführungsbeispiel.

Die Figuren 1 und 2 wurden bereits einleitend beschrieben. Sie erklären die Erzeugung und Verwendung von PWM-Signalen PWM für einen Umrichter U anhand des Vergleichs eins analogen Dreiecksignals Ud und analoger Steuersignale Ud.

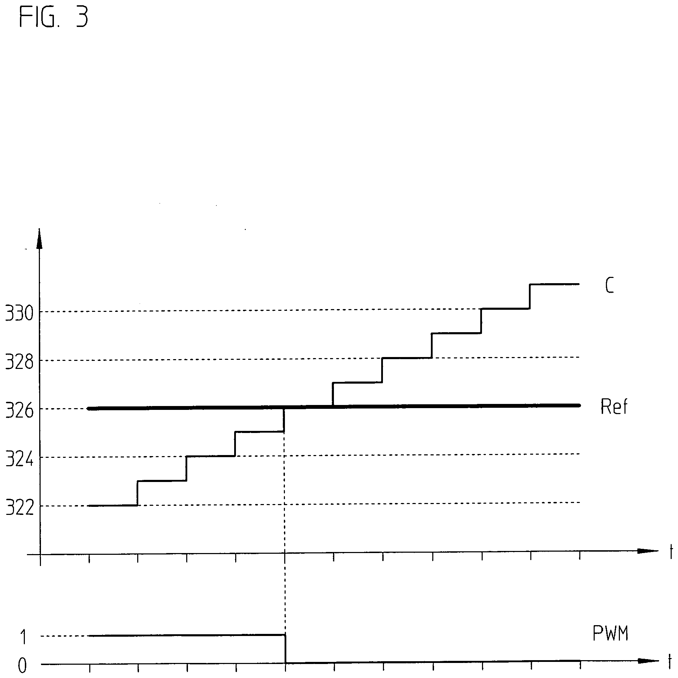

Die Figur 3 erklärt, wie mit einer Digitalschaltung ein PWM-Signal PWM erzeugt werden kann. Das analoge Dreiecksignal Ud der Figur 2 ist durch eine digitale Zählrampe C ersetzt, die analoge Steuerspannung Us, Vs, Ws ist durch einen Referenzwert Ref ersetzt. Die Figur 3 zeigt der besseren Übersichtlichkeit halber nur den Referenzwert Ref für eine Phase. In diesem Beispiel hängt der logische Zustand des PWM-Signals PWM zur Ansteuerung der Leistungstransistoren T davon ab, ob der Referenzwert Ref größer als der Zählerstand der Zählrampe C ist. Solange diese Bedingung erfüllt ist, liegt das PWM-Signal auf einem High - Pegel, ansonsten auf einem Low - Pegel. Das PWM-Signal eignet sich damit zur direkten Ansteuerung des oberen der beiden Leistungstransistoren T einer Halbbrücke B des Umrichters U in Figur 1. Um den unteren Leistungstransistor T anzusteuern, muss das PWM-Signal PWM noch invertiert werden. Es sind außerdem Maßnahmen zur Einhaltung der Totzeit beim Umschalten zwischen den beiden Transistoren zu treffen.

Für eine Applikation, die eine sehr genaue Ansteuerung des Elektromotors M erfordert, kann beispielsweise eine PWM-Frequenz (entsprechend der Frequenz des Dreiecksignals Ud der Figur 2) von 144 kHz gefordert sein. Wenn der Referenzwert Ref dabei mit einer hohen Auflösung von 10 Bit vorgegeben werden soll, so muss auch die Zählrampe C mit dieser Auflösung zählen. Innerhalb einer Periode der PWM-Frequenz muss die Zählrampe C damit einmal von 0 bis 1023 zählen und wieder von 1023 zurück auf 0, um einen dem Analogsignal entsprechenden Dreiecks - Verlauf zu erhalten. Daraus ergibt sich, dass der Zähler mit einer Frequenz von 1024*2*144 kHz gleich 295 MHz zählen muss. Dies ist ein Wert, der derzeit nur mit sehr aufwändigen und teuren digitalen Schaltungen erreicht werden kann.

Um einen preiswerten digitalen Baustein wie beispielsweise ein FPGA verwenden zu können, wird daher vorgeschlagen, mit zwei Zählern zu arbeiten, die dann nur mit der halben Frequenz zählen müssen, um PWM-Signale der gewünschten Qualität zu erzeugen. Prinzipiell ist auch die Verwendung von mehr als zwei Zählern ohne weiteres möglich, es steigt dann lediglich der Aufwand zum Synchronisieren und Auswerten der Zähler. Im gegebenen Beispiel erreicht man bereits mit zwei Zählern Zählfrequenzen, die mit günstig erhältlichen Bausteinen zu realisieren sind.

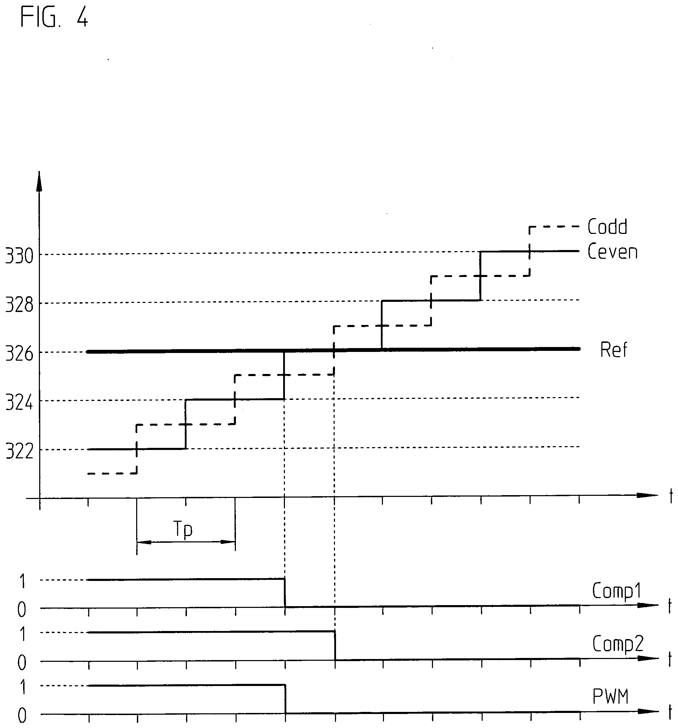

Die Figur 4 zeigt, dass mit zwei Zählrampen Codd, Ceven, die jeweils mit einer im Vergleich zur Figur 3 halbierten Zählfrequenz bzw. einer verdoppelten Zählperiode Tp nur die geraden bzw. die ungeraden Zahlen zählen, ein PWM-Signal PWM zu erzeugen ist, das dem der Figur 3 völlig entspricht. Hierzu muss der Referenzwert Ref mit den Zählerständen jeder der beiden Zählrampen Codd, Ceven verglichen werden. Vergleichssignale Comp1, Comp2 geben jeweils an, ob der Referenzwert Ref größer als der Zählerstand der jeweiligen Zählrampe Codd, Ceven ist. Verknüpft man die beiden Vergleichssignale Comp1, Comp2 mit einem logischen UND, so erhält man daraus ein PWM-Signal PWM, das sich wie das PWM-Signal PWM der Figur 3 verhält.

Die beiden Zählrampen Codd, Ceven müssen bestimmte Bedingungen einhalten, um ein optimales Ergebnis zu erzielen. So müssen sie gegeneinander um eine halbe Zählperiode Tp verschoben sein. Dies lässt sich mit PLL (Phase Locked Loop) - Schaltungen auf einfache Weise realisieren. Solche PLL - Schaltungen zur Generierung zusätzlicher Taktsignale sind in vielen FPGAs bereits integriert. Die Phasenlage einer solchen PLL - Schaltung lässt sich einfach parametrieren und wird sehr genau kontrolliert.

Es ist außerdem darauf zu achten, dass am oberen und unteren Umkehrpunkt der Zählrampen Codd, Ceven derjenige Zähler, der zuletzt an seinem Umkehrpunkt ankommt, diesen als erstes wieder verlässt.

Durch diese zweite Bedingung ergäbe sich für Referenzwerte Ref auf oder in unmittelbarer Nähe von den beiden Umkehrpunkten der Zählrampen Codd, Ceven ein Verhalten des PWM-Signals PWM, das nicht vollständig mit dem übereinstimmt, das sich mit nur einem schnellen Zähler ergibt. Dies ist aber unerheblich, da in der Praxis Referenzwerte Ref nicht in die Nähe der Umkehrpunkte gelangen. Die dabei entstehenden Ein- bzw. Ausschaltzeiten sind so kurz, dass die Leistungstransistoren gar nicht in der Lage wären, solche PWM-Signale umzusetzen. In dem oben angeführten Zahlenbeispiel läge die Einschaltdauer des oberen Leistungstransistors bei einem Referenzwert Ref von "1" bei nur noch ca. 7 ns. Solche Werte sind jedoch schon wegen der einzuhaltenden Totzeit nicht möglich, die je nach verwendetem Verstärker zwischen 100 ns und 2 µs liegt. Es werden daher z.B. bei einem Wertebereich der Zählrampen von 0 bis 1023 Referenzwerte Ref zwischen 50 und 973 verwendet. Der Wertebereich der Zählrampen Codd, Ceven wird also für den Referenzwert Ref nicht vollständig ausgenützt, es verbleibt ein Sicherheitsabstand von einigen Prozent des Wertebereichs zu den Grenzen des Wertebereichs.

Um mit herkömmlichen Mitteln die erwähnte Totzeit zu berücksichtigen ist eine Logik nötig, die mit mindestens dem Takt der verwendeten "effektiven Zählrampe" betrieben wird. Ein solcher hochfrequenter Takt steht aber im vorstehenden Ausführungsbeispiel nicht zur Verfügung, da die Zählrampe mit zwei langsameren, phasenverschobenen Zählern realisiert ist. Das folgende Ausführungsbeispiel löst dieses Problem, indem die Einhaltung der Totzeit nur mit kombinatorischer Logik sichergestellt wird, ohne einen zusätzlichen hochfrequenten Takt zu benützen.

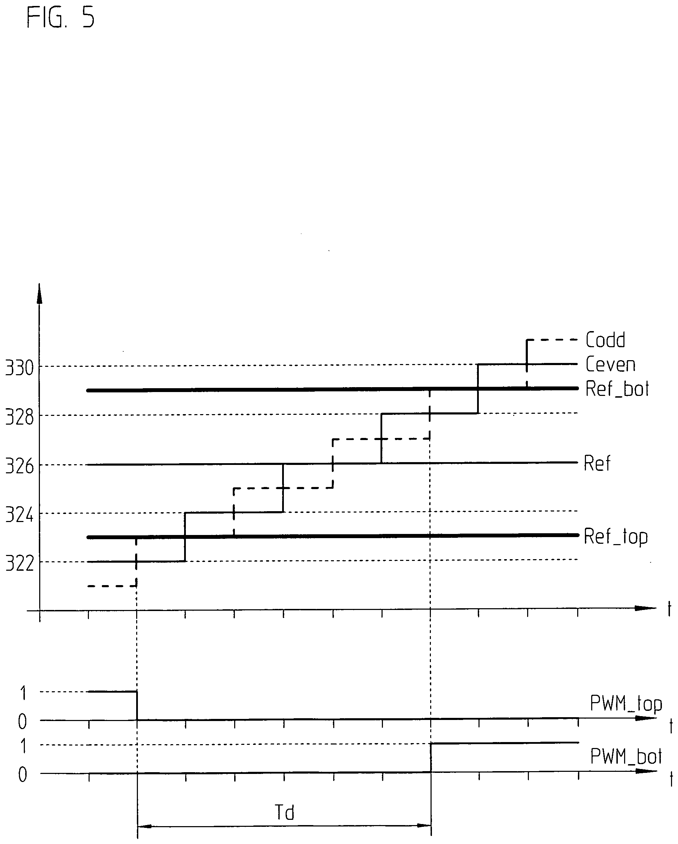

Anhand der Figur 5 wird ein weiteres Ausführungsbeispiel beschrieben. Wie im ersten Ausführungsbeispiel kommen zwei Zählrampen Codd, Ceven zum Einsatz. Es werden aber nun zwei voneinander verschiedene Referenzwerte Ref_bot bzw. Ref_top für den unteren bzw. oberen Leistungstransistor T einer Halbbrücke B des Umrichters U aus Figur 1 verwendet. Wie gezeigt wird, lässt sich so auf einfachste Weise eine Totzeit Td beim Umschalten zwischen den Leistungstransistoren T einhalten.

In der Figur 5 ist gezeigt, dass der Umschaltzeitpunkt des PWM-Signals PWM_top für den oberen Leistungstransistor T früher liegt als der Umschaltzeitpunkt des PWM-Signals PWM_bot für den unteren Leistungstransistor. Das PWM-Signal PWM_top wurde mit der selben Logik erhalten wie das PWM-Signal PWM der Figur 4. Es liegt dann auf einem High - Pegel, wenn der Referenzwert Ref_top größer ist als der Zählerstand jeder der beiden Zählrampen Codd, Ceven. Entsprechend wird für das. PWM-Signal PWM_bot der Referenzwert PWM_bot mit den Zählerständen der Zählrampen Codd, Ceven verglichen und das Ergebnis dieses Vergleichs zusätzlich invertiert. Man erkennt, dass beide Leistungstransistoren T für eine Totzeit Td abgeschaltet sind. Ein Kurzschluss der Zwischenkreisspannung des Umrichters U durch verzögert ansprechende Leistungshalbleiter T ist somit ausgeschlossen.

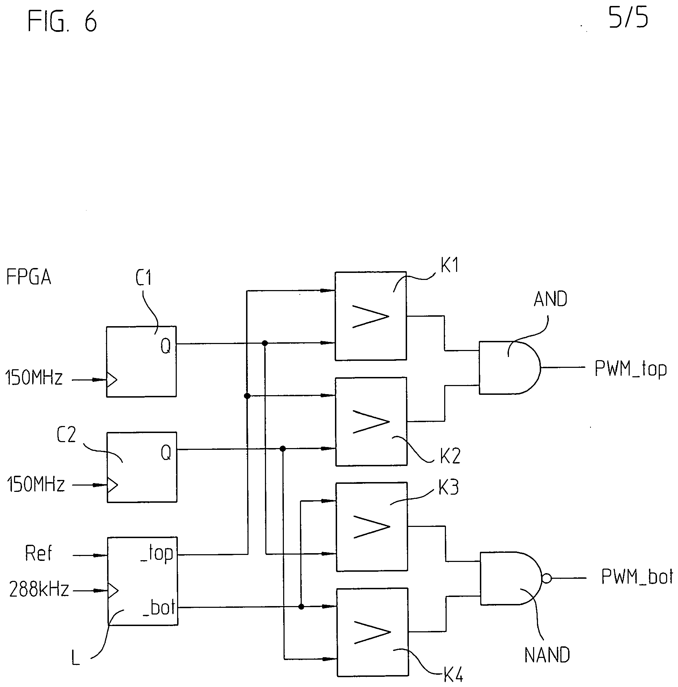

Figur 6 zeigt ein Blockschaltbild der Logik, mit der das zweite Ausführungsbeispiel gemäß Figur 5 umgesetzt werden kann.

Zwei Zähler C1 und C2 werden mit 150 MHz getaktet. Der Zähler C1 zählt die Zählrampe Codd, der Zähler C2 zählt die Zählrampe Ceven der Figur 5. Beide Zähler sind um eine halbe Zählperiode gegeneinander verschoben.

Ein Logikbaustein L nimmt einen Referenzwert Ref entgegen und erzeugt daraus die zwei Referenzwerte Ref_bot und Ref_top der Figur 5. Der Mittelwert der beiden Referenzwerte Ref_bot und Ref_top entspricht gerade dem ursprünglichen Referenzwert Ref, der proportional zu einer benötigten Spannung an einem Ausgang der Halbbrücke (B) ist. Auf diese Weise wird die Totzeit Td symmetrisch um den ursprünglichen Schaltzeitpunkt verteilt.

Ein Komparator K1 prüft, ob der Referenzwert Ref_top größer ist als der Zählerstand von C1. Ein Komparator K2 prüft, ob der Referenzwert Ref_top größer ist als der Zählerstand von C2. Die Ausgänge der beiden Komparatoren K1, K2 ergeben mit einem logischen UND verknüpft das PWM-Signal PWM_top zur Ansteuerung des oberen Leistungstransistors T einer Halbbrücke.

Ein Komparator K3 prüft, ob der Referenzwert Ref_bot größer ist als der Zählerstand von C1. Ein Komparator K4 prüft, ob der Referenzwert Ref_bot größer ist als der Zählerstand von C2. Die Ausgänge der beiden Komparatoren K3, K4 ergeben mit einem logischen NICHT-UND (NAND) verknüpft das PWM-Signal PWM_bot zur Ansteuerung des unteren Leistungstransistors T einer Halbbrücke.

Beide hier gezeigten Ausführungsbeispiele ermöglichen die Generierung von PWM-Signalen zur Ansteuerung der Leistungstransistoren in einem Umrichter, wobei ein Referenzwert mit 10 Bit Auflösung gegen einen Zähler mit ebenfalls 10 Bit Auflösung bei einer Zählfrequenz von 295 MHz verglichen wird. Dies gelingt, obwohl intern nur ein Takt von ca. 150 MHz zur Verfügung steht. Gemäß dem zweiten Ausführungsbeispiel werden die PWM-Signale für den oberen und unteren Leistungstransistor einer Halbbrücke in einem Umrichter so erzeugt, dass die Totzeit beim Umschalten zwischen den beiden Leistungshalbleitern eingehalten wird, ohne dass dafür noch weitere Maßnahmen nötig wären.

Wenn in den vorstehenden Ausführungsbeispielen und in den Ansprüchen die Bedingung "Referenzwert ist größer als Zählerstand" verwendet wird, so ist damit entweder die Bedingung "ist größer", oder alternativ auch die Bedingung "ist größer oder gleich" gemeint, denn ob bei Gleichheit von Referenzwert und Zählerstand das entsprechende PWM-Signal auf einem High - Pegel oder auf einem Low - Pegel liegt, ist unerheblich und kann nach belieben festgelegt werden.

## Patentansprüche

1. Verfahren zum Erzeugen eines PWM-Signals zum Ansteuern der Leistungstransistoren (T) einer Halbbrücke (B) eines Umrichters (U) mittels einer digitalen Schaltung (FPGA), nach dem ein digitaler Referenzwert (Ref) mit dem Zählerstand einer digitalen Zählrampe (C) verglichen wird, wobei ein logischer Zustand des PWM-Signals (PWM) davon abhängt, ob der Referenzwert (Ref) größer als der Zählerstand der Zählrampe (C) ist, **dadurch gekennzeichnet, dass** wenigstens zwei Zähler (C1, C2) einander abwechselnd aufeinander folgende Zählerstände der Zählrampe (C) zählen, und dass der logische Zustand des PWM-Signals (PWM) davon abhängt, ob der Referenzwert (Ref) größer als der Zählerstand von Zählrampen (Codd, Ceven) von jedem der wenigstens zwei Zähler (C1, C2) ist.

2. Verfahren nach Anspruch 1, **dadurch gekennzeichnet, dass** zwei Zähler (C1, C2) mit gleicher Zählperiode (Tp) um eine halbe Zählperiode (Tp) versetzt zählen.

3. Verfahren nach Anspruch 1 oder 2, **dadurch gekennzeichnet, dass** an einem oberen oder unteren Umkehrpunkt der gemäß einem Dreiecksverlauf zählenden Zählrampen (Codd, Ceven) derjenige Zähler (C1, C2), der zuletzt an seinem Umkehrpunkt ankommt, diesen als erstes wieder verlässt.

4. Verfahren nach einem der vorhergehenden Ansprüche, **dadurch gekennzeichnet, dass** ein Wertebereich des Referenzwertes (Ref, Ref_bot, Ref_top) kleiner ist als ein Wertebereich der wenigstens zwei Zähler (C1, C2).

5. Verfahren nach einem der vorhergehenden Ansprüche, **dadurch gekennzeichnet, dass** für jeden der beiden Leistungstransistoren (T) der Halbbrücke (B) ein eigener Referenzwert (Ref_bot, Ref_top) zum Vergleich mit den Zählerständen der Zählrampen (Codd, Ceven) herangezogen wird, so dass die abgeleiteten PWM-Signale (PWM_bot, PWM_top) eine Totzeit (Td) einhalten.

6. Verfahren nach Anspruch 5, **dadurch gekennzeichnet, dass** die für jeden der beiden Leistungstransistoren (T) der Halbbrücke (B) vorgesehenen eigenen Referenzwerte (Ref_bot, Ref_top) symmetrisch um den Referenzwert (Ref) liegen, der proportional zu einer benötigten Spannung an einem Ausgang der Halbbrücke (B) ist.

## Claims

1. Method for generating a PWM signal for driving the power transistors (T) of a half-bridge (B) of a converter (U) by means of a digital circuit (FPGA), according to which a digital reference value (Ref) is compared with the counter reading of a digital counter ramp (C), wherein a logic state of the PWM signal (PWM) is dependent on whether the reference value (Ref) is greater than the counter reading of the counter ramp (C), **characterized in that** at least two counters (C1, C2) mutually alternately count successive counter readings of the counter ramp (C), and **in that** the logic state of the PWM signal (PWM) is dependent on whether the reference value (Ref) is greater than the counter reading of counter ramps (Codd, Ceven) of each of the at least two counters (C1, C2).

2. Method according to Claim 1, **characterized in that** two counters (C1, C2) count with an identical counting period (Tp), in a manner offset by half a counting period (Tp).

3. Method according to Claim 1 or 2, **characterized in that** at a top or bottom reversal point of the counter ramps (Codd, Ceven) counting in accordance with a triangular profile, that counter (C1, C2) which is the last to arrive at its reversal point is the first to leave said reversal point again.

4. Method according to any of the preceding claims, **characterized in that** a value range of the reference value (Ref, Ref_bot, Ref_top) is smaller than a value range of the at least two counters (C1, C2).

5. Method according to any of the preceding claims, **characterized in that** for each of the two power transistors (T) of the half-bridge (B), a dedicated reference value (Ref_bot, Ref_top) is used for comparison with the counter readings of the counter ramps (Codd, Ceven), such that the derived PWM signals (PWM_bot, PWM_top) comply with a dead time (Td).

6. Method according to Claim 5, **characterized in that** the dedicated reference values (Ref_bot, Ref_top) provided for each of the two power transistors (T) of the half-bridge (B) lie symmetrically about the reference value (Ref) which is proportional to a required voltage at an output of the half-bridge (B).

## Revendications

1. Procédé pour générer un signal PWM destiné à commander les transistors de puissance (T) d'un demi-pont (B) d'un convertisseur (U) au moyen d'un circuit numérique (FPGA), après qu'une valeur de référence numérique (Ref) a été comparée à l'état d'un compteur d'une rampe de comptage numérique (C), dans lequel un état logique du signal PWM (PWM) dépend du fait que la valeur de référence (Ref) est ou non supérieure à l'état de compteur de la rampe de comptage (C), **caractérisé en ce qu'**au moins deux compteurs (C1, C2) comptent des états de compteur alternativement consécutifs de la rampe de comptage (C), et **en ce que** l'état logique du signal PWM (PWM) dépend du fait que la valeur de référence (Ref) est ou non supérieure à l'état de compteur de rampes de comptage (Codd, Ceven) des au moins deux compteurs (C1, C2).

2. Procédé selon la revendication 1, **caractérisé en ce que** deux compteurs (C1, C2) comptent avec des périodes de comptage (Tp) identiques décalées d'une moitié de période de comptage (Tp).

3. Procédé selon la revendication 1 ou 2, **caractérisé en ce que**, au niveau d'un point d'inflexion supérieur ou inférieur des rampes de comptage (Codd, Ceven) comptant selon un trajet triangulaire, le compteur (C1, C2) qui atteint en dernier son point d'inflexion quitte de nouveau ce dernier en tant que premier.

4. Procédé selon l'une quelconque des revendications précédentes, **caractérisé en ce qu'**une plage de valeurs de la valeur de référence (Ref, Ref_bot, Ref_top) est inférieure à une plage de valeurs des au moins deux compteurs (C1, C2).

5. Procédé selon l'une quelconque des revendications précédentes, **caractérisé en ce que**, pour chacun des deux transistors de puissance (T) du demi-pont (B), une valeur de référence propre (Ref_bot, Ref_top) est soumise à une comparaison avec les états de compteur des rampes de comptage (Codd, Ceven) de manière à ce que les signaux PWM obtenus (PWM_bot, PWM_top) contiennent un temps mort (Td).

6. Procédé selon l'une quelconque des revendications précédentes, **caractérisé en ce que**, pour chacun des deux transistors de puissance (T) du demi-pont (B), des valeurs de référence propres (Ref_bot, Ref_top) soient situées de manière symétrique par rapport à la valeur de référence (Ref), qui est proportionnelle à une tension requise à une sortie du demi-pont (B).
